# EUROPEAN PATENT SPECIFICATION

(11) **EP 1 870 772 B1**
(45) Date of publication and mention of the grant of the patent: **23.10.2013**
(21) Application number: 07018092.2
(22) Date of filing: 17.03.2003
(51) Int. Cl.: G03F 7/20

(54) **Lithographic apparatus**
Lithografische Vorrichtung
Appareil lithographique

(30) Priority: 18.03.2002 EP 02251933
(43) Date of publication of application: 26.12.2007
(62) Divisional of application: 03251611.4
(73) Proprietor: ASML Netherlands B.V., 5504 DR Veldhoven (NL)
(72) Inventor: Dierichs, Marcel Mathijs Theodore Marie, 5914 WR Venlo (NL)
(74) Representative: Slenders, Petrus J. W.

(56) References cited:
- EP-A- 0 939 341
- EP-A- 1 026 547
- EP-A- 1 109 067
- EP-A- 1 202 101
- EP-A- 1 291 721
- EP-A1- 1 262 836
- DE-A1- 19 935 568
- JP-A- 6 291 023
- US-A- 5 339 346
- US-B1- 6 225 027

## Description

The present invention relates to a lithographic projection apparatus comprising:
- a radiation system comprising reflective optical elements for supplying a projection beam of radiation, said reflective optical elements including a first faceted mirror for generating a plurality of source images on a second faceted mirror;
- a support structure for supporting patterning means, the patterning means serving to pattern the projection beam according to a desired pattern;
- a substrate table for holding a substrate;
- a projection system for projecting the patterned beam onto a target portion of the substrate, and
- facet masking means (12, 13) for selectively masking the whole of one or more of the facets of said first faceted mirror.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:
- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation bearn, and that it can be moved relative to the beam if so desired.
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096, which are incorporated herein by reference. In the case of a programmable mirror array, the said support structure may be embodied as a frame or table, for example, which may be fixed or movable as required.
- A programmable LCD array. An example of such a construction is given in United States Patent US 5,229,872, which is incorporated herein by reference. As above, the support structure in this case may be embodied as a frame or table, for example, which may be fixed or movable as required.
For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (e.g. comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus - commonly referred to as a step-and-scan apparatus - each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792, incorporated herein by reference.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4, incorporated herein by reference.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791, incorporated herein by reference.

In a lithographic apparatus, it is very important that illumination of the patterning means is uniform in field and angle distribution and, for illumination modes such as dipole and quadrupole illumination, all poles are equal. To achieve this, an integrator is provided in the illumination system. In a lithographic apparatus using UV or DUV exposure radiation the integrator may take the form of a quartz rod or a so-called fly's eye lens. A fly's eye lens is a lens built up of a large number of smaller lenses in an array which creates a correspondingly large number of images of the source in a pupil plane of the illumination system. These images act as a virtual, or secondary, source. However, when using EUV exposure radiation the illumination system must be constructed from mirrors because there is no known material suitable for forming a refractive optical element for EUV radiation. US6225027 discloses an illumination system comprising reflective optical elements for supplying a projection beam of radiation, said reflective optical elements including a first faceted mirror for generating a plurality of ring images. DE 19935568 discloses an illumination system comprising reflective optical elements for supplying a projection beam of radiation. The reflective optical elements include a first faceted mirror for generating a plurality of source images on a second faceted mirror. JP6291023 discloses an illumination system based on a conventional fly's eye light mixer. EP0939341 discloses an illumination system comprising reflective optical elements for supplying a projection beam of radiation, the reflective optical elements include a first faceted mirror for generating a plurality of source images on a second faceted mirror. EP1026547 discloses an illumination system comprising reflective optical elements for supplying a projection beam of radiation, said reflective optical elements include a first faceted mirror for generating a plurality of source images on a second faceted mirror. In such an illumination system, a functional equivalent to a fly's eye lens can be provided using faceted mirrors, for instance as described in US 6,195,201, US 6,198,793 and EP-A-0 939 341, the contents of which are hereby incorporated by reference. These documents describe a first, or field, faceted mirror which focuses a plurality of images, one per facet, on a second, or pupil, faceted mirror which directs the light to appropriately fill the pupil of the projection system. It is known from UV and DUV lithography that imaging of different types of mask pattern can be improved by controlling the illumination settings, *e.g.* the filling ratio of the pupil of the projection system (commonly referred to as σ) or the provision of special illumination modes such as annular, dipole or quadrupole illumination. More information on illumination settings can be obtained from EP-A- 0 949 541 and EP-A-1 109 067, for example, which documents are hereby incorporated by reference. In an EUV lithographic apparatus with a fly's eye interpreter, these illumination settings can be controlled by selectively blocking certain of the pupil facets. However, because the source position and size on each facet is not exactly known and not stable, it is necessary to block off whole facets at a time, rather than partial facets. Thus, only relatively coarse control of illumination settings is possible. Also, to provide an annular illumination setting it is necessary to obscure the innermost pupil facets and when positioning a masking blade over an inner facet it is difficult to avoid partially obscuring one or more of the outer facets.

It is an object of the present invention to provide a lithographic apparatus with an illumination system comprising reflective optical elements that allows improved control over the illumination settings.

This and other objects are achieved according to the invention in a lithographic apparatus as specified in the opening paragraph, characterized by: facets pear the periphery of the first facet mirror being arranged to direct radiation to more centrally positioned facets of the second facet mirror.

By using a partially-opaque masking blade to selectively mask one or more facets, part of the radiation from that facet can be blocked without causing unacceptable inhomogeneity in the illumination of the patterning means, irrespective of the fact that the exact location of the source image on the pupil facet is not known. In this way, intermediate illumination settings, between masking and not masking whole facets or rings of facets, can be provided.

The pitch should be small relative to the source image, so that the proportion of radiation blocked is independent of the source position, but not sufficiently small to cause diffraction of the projection beam. Preferably, for an apparatus using EUV as the exposure radiation, the pitch is in the range of from 1mm to 500nm, dependent on the size of the facets and the illuminated area.

The facet masking means preferably further comprises means for adjusting the proportion of the area of a facet that is obscured, for example by having a plurality of partially-opaque blades selectively interposable into said projection beams. This enables multiple intermediate illumination settings, providing further versatility.

Preferably, the facet masking means are arranged proximate the second (pupil) faceted mirror as this provides the most homogeneous illumination of the patterning means.

Since all radiation from one facet of the first (field) faceted mirror is incident on one facet of the second faceted mirror, equivalent illumination control can be achieved by selectively blocking field facets as by blocking pupil facets. Normally however, it would not be contemplated to control illumination settings, such as σ, at this position since this is not a pupil plane and so selective obscuration at this position would be expected to cause non-uniformities in the illumination of the patterning means. However, because the field and pupil mirrors are faceted, selective masking of whole field facets can be performed without unacceptable loss of uniformity.

The facets may be arranged so that field facets illuminate pupil facets in different positions, for example facets near the periphery of the field facet mirror may direct radiation to more centrally positioned facets of the pupil facet mirror. Thus annular illumination modes may be set more easily, without partial obscuration of the outer pupil facets and illumination modes that would require masking of inaccessible pupil faces can be set.0

Of course, a facet masking means of a second aspect may be the same as that of the first aspect and the two aspects may be combined to have selective masking of both field and pupil facets. Thereby, independent control of the inner and outer radii (σᵢₙₙₑᵣ and σₒᵤₜₑᵣ) of an annular illumination mode can be achieved.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet radiation (*e.g.* with a wavelength of 365, 248, 193, 157 or 126 nm) and extreme ultra-violet radiation (EUV), *e.g.* having a wavelength in the range 5-20 nm, especially around 13nm, as well as particle beams, such as ion beams or electron beams.

Embodiments of the invention will now be described, by way of example only, with reference to the accompanying schematic drawings in which:
Figure 1 depicts a lithographic projection apparatus according to an embodiment of the invention;
Figure 2 depicts certain components of the illumination system of the apparatus of Figure 1;
Figures 3 to 5 depict the facet masking means of the first embodiment of the invention in various positions;
Figure 6 depicts a partially opaque masking blade used in the first embodiment of the invention;
Figure 7 depicts certain components of the illumination system of a second embodiment of the invention; and
Figure 8 depicts the field facet mirror of the second embodiment of the invention.

In the Figures, corresponding reference symbols indicate corresponding parts.

### Embodiment 1

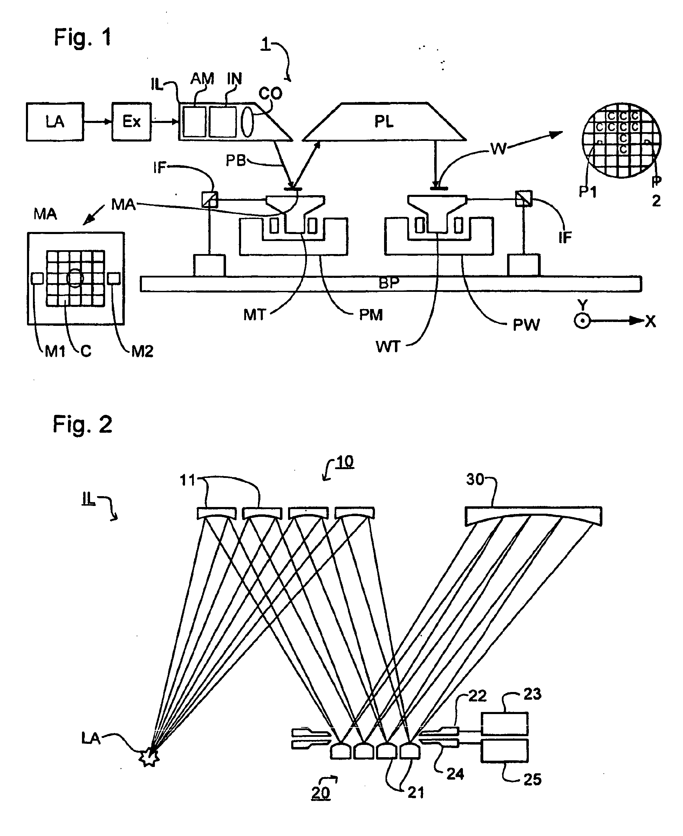

Figure 1 schematically depicts a lithographic projection apparatus according to a particular embodiment of the invention. The apparatus comprises:
a radiation system Ex, IL, for supplying a projection beam PB of radiation (*e.g.* EUV radiation), which in this particular case also comprises a radiation source LA;
a first object table (mask table) MT provided with a mask holder for holding a mask MA (e.g. a reticle), and connected to first positioning means PM for accurately positioning the mask with respect to item PL;
a second object table (substrate table) WT provided with a substrate holder for holding a substrate W (*e.g.* a resist-coated silicon wafer), and connected to second positioning means PW for accurately positioning the substrate with respect to item PL;
a projection system ("lens") PL (*e.g.* a mirror group) for imaging an irradiated portion of the mask MA onto a target portion C (*e.g*. comprising one or more dies) of the substrate W.
As here depicted, the apparatus is of a reflective type (*e.g.* has a reflective mask). However, in general, it may also be of a transmissive type, for example (*e.g.* with a transmissive mask). Alternatively, the apparatus may employ another kind of patterning means, such as a programmable mirror array of a type as referred to above.

The source LA (*e.g.* a laser-produced or discharge plasma source) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and Claims encompass both of these scenarios.

The beam PB subsequently intercepts the mask MA, which is held on a mask table MT. Having been selectively reflected by the mask MA, the beam PB passes through the lens PL, which focuses the beam PB onto a target portion C of the substrate W. With the aid of the second positioning means (and interferometric measuring means IF), the substrate table WT can be moved accurately, e.g. so as to position different target portions C in the path of the beam PB. Similarly, the first positioning means can be used to accurately position the mask MA with respect to the path of the beam PB, e.g. after mechanical retrieval of the mask MA from a mask library, or during a scan. In general, movement of the object tables MT, WT will be realized with the aid of a long-stroke module (course positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed.

The depicted apparatus can be used in two different modes:
1. In step mode, the mask table MT is kept essentially stationary, and an entire mask image is projected in one go (*i.e.* a single "flash") onto a target portion C. The substrate table WT is then shifted in the x and/or y directions so that a different target portion C can be irradiated by the beam PB;
2. In scan mode, essentially the same scenario applies, except that a given target portion C is not exposed in a single "flash". Instead, the mask table MT is movable in a given direction (the so-called "scan direction", *e.g.* the y direction) with a speed *v*, so that the projection beam PB is caused to scan over a mask image; concurrently, the substrate table WT is simultaneously moved in the same or opposite direction at a speed *V* = *Mv*, in which *M* is the magnification of the lens PL (typically, *M* = 1/4 or 1/5). In this manner, a relatively large target portion C can be exposed, without having to compromise on resolution.

As shown in Figure 2, the illumination system includes a field faceted mirror 10, having a plurality of facets 11, which receive radiation from the radiation source LA and form a plurality of images of the source LA on corresponding facets of pupil faceted mirror 22. The pupil facets 21, with the remainder of the illumination system, redirect the radiation such that the images of the field facets overlap on the patterning means. The shape of the field facets 11 largely define the shape of the illumination field on the patterning means.

To control the illumination settings for illuminating the mask, facet masking means 22-25 are provided. Facet masking means 22-25 comprise a partially-opaque masking blade 22 and a solid masking blade 24 connected to respective actuators 23, 25 so as to be selectively and incrementally closeable into the projection beam PB in front of respective facets of the pupil facet mirrors. Because the image in the pupil of the projection system PL is an image of the pupil faceted mirror 20 (they are in conjugate planes), selectively obscuring the outermost ones of the pupil facets 21 allows control over σ, the ratio of the amount of the projection system pupil that is filled, if no diffraction (at the mask) were present. Obscuring the outermost facets reduces σ.

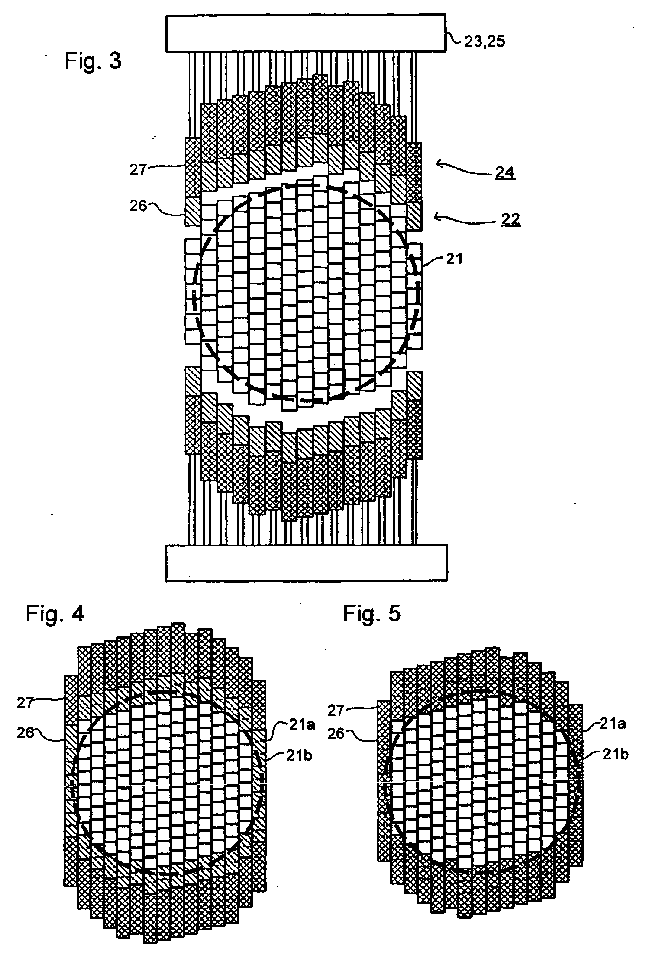

The facet masking means 22,23,24,25 and their operation, are shown in greater detail in Figures 3 to 6. Although in these figures the partially-opaque masking blade 22 is shown as solid, it will comprise as large a number of apertures and opaque areas as possible subject to the constraint that the size and spacing of the apertures and opaque areas must be large compared to the wavelength of the projection beam so that diffraction does not occur and to practical considerations of manufacture. The opaque areas preferably have a total area sufficient to reduce by a predetermined fraction, preferably 50%, the radiation reflected by the pupil facet. It will be appreciated that since the projection beam is not incident on the pupil mirror 20 exactly normally, if the facet masking means are at all spaced from the pupil mirror 20, the total opaque area of the partially-opaque masking blade 22 as a fraction of the area of one of the facets will be a little less than the predetermined fraction of the projection beam that is to be absorbed.

As can be seen in Figure 3, the pupil facets 21 are square and arranged in columns. Accordingly, the partially-opaque and solid masking blades 22, 24 are constructed as a plurality of fingers 26, 27, one of each per column of pupil facets, that are selectively and incrementally extendible to cover ones of the pupil facets. Preferably, independent control of each of the fingers 26, 27 is provided to enable greater flexibility of the illumination settings, however in some circumstances pairs or groups of fingers may be ganged together.

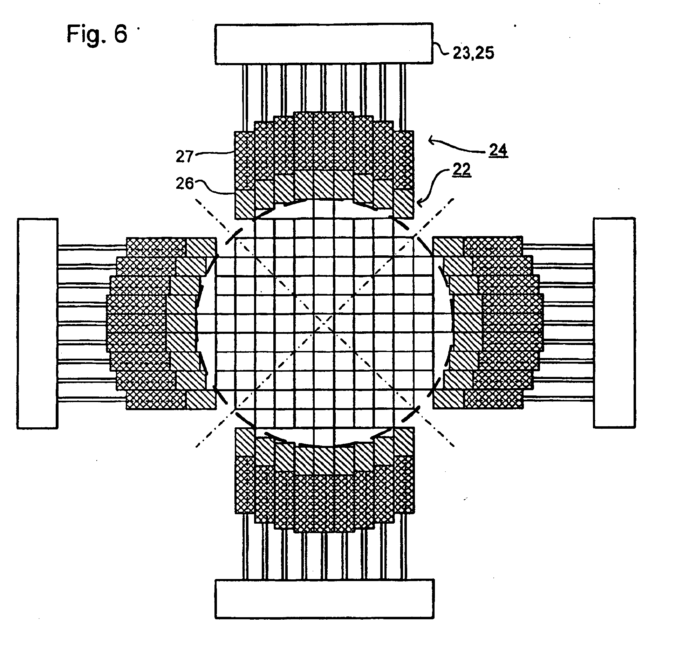

The partially-opaque masking blades 27 may be constructed, for example, as a grid of rods, bars or wires or by forming apertures in a suitable pattern in a solid plate. A partially opaque masking blade 27 formed with a plurality of rods 29 is shown in Figure 6.

In general, for other shapes and arrangements of pupil facets, the masking blades 22, 24 may be arranged differently. For example, for pupil facets arranged in concentric rings, the masking blades may take the form of iris diaphragms. As an alternative to adjustable blades, it is possible to provide a plurality of blades, opaque and partially opaque, corresponding to the desired illumination settings and selectively interpose these into the beam as desired. Such fixed blades may be formed as plates with appropriate openings and partially opaque (apertured) areas and may be held in a magazine or carousel to be inserted into the beam.

Figure 3 shows the facet masking means in its neutral position, with both masking blades 22,24 (fingers 26,27) open leaving the pupil facets 21 clear. This setting provides the greatest σ. To reduce σ by the smallest amount, effectively a half step, the partially-opaque fingers 26 are extended one step so that the outermost ring of pupil facets 21a is covered, as shown in Figure 4. The solid fingers 27 remain fully retracted and the inner pupil facets 21 b are uncovered. To reduce σ further, the solid fingers 27 are extended one step, fully obscuring the outermost ring of pupil facets 21a, as shown in Figure 5. Again, the inner pupil facets 21 b remain uncovered. Further reductions in σ are achieved by further extending the fingers 26, 27 - extending the solid fingers 27 reduces σ in whole steps, whilst extending the partially-opaque fingers 26 one step more provides a half step reduction in σ. Extending the partially-opaque fingers 26 more than one step more than the solid fingers 27 provides an illumination intensity distribution with a more gradual decrease towards the edge of the pupil. Note that to provide circular illumination modes, the outermost fingers will move to obscure a whole column of facets whilst the central fingers advance only one facet width. When the central fingers move a further facet inwards the next outermost column will be obscured and so on. The aim being that the area of unobscured facets is as close to circular as possible.

By providing multiple partially-opaque masking blades with different blocking ratios, smaller increments in σ can be provided. For example, with two appropriately aligned partially-opaque masking blades, one blocking 25% of the radiation and one blocking 50%, quarter steps can be provided - the 25% masking blade extended one step more that the solid masking blade provides a quarter step, the 50% masking blade extended one step more gives a half step and both extended one step more gives a three quarter step.

Although the configurations illustrated are rotationally-symmetrical this is not always required or desired. For example, an elliptical pupil configuration may be created by covering facets in one direction only and multipole configurations may be created by covering the appropriate facets only.

In a variant of the first embodiment, four sets of facet marking blades are used, arranged around four sides of the facet mirror. This is shown in Figure 6 and can provide circular illumination modes with shorter movements of the fingers when the facets are arranged on a square grid.

### Embodiment 2

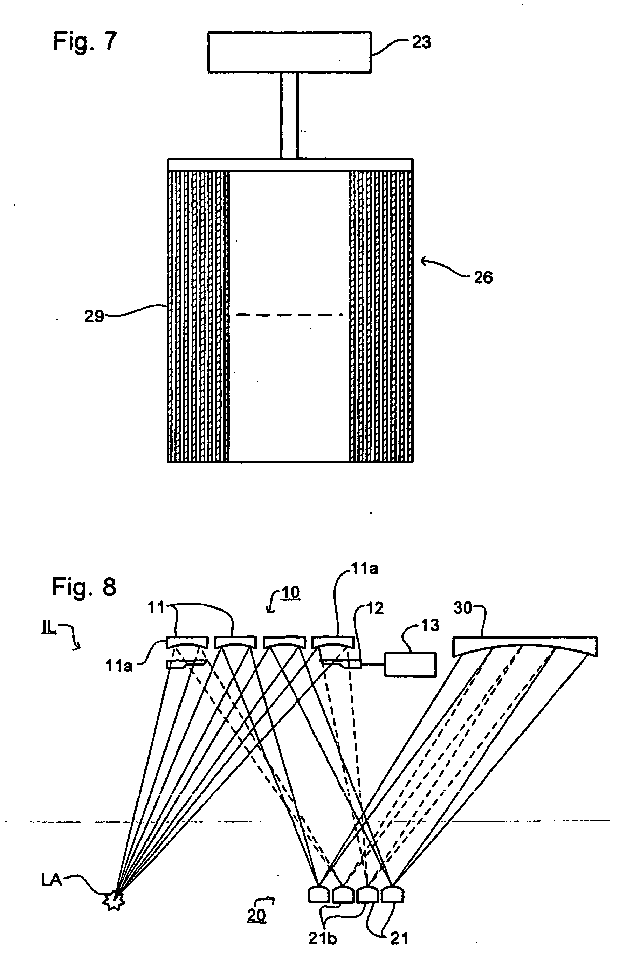

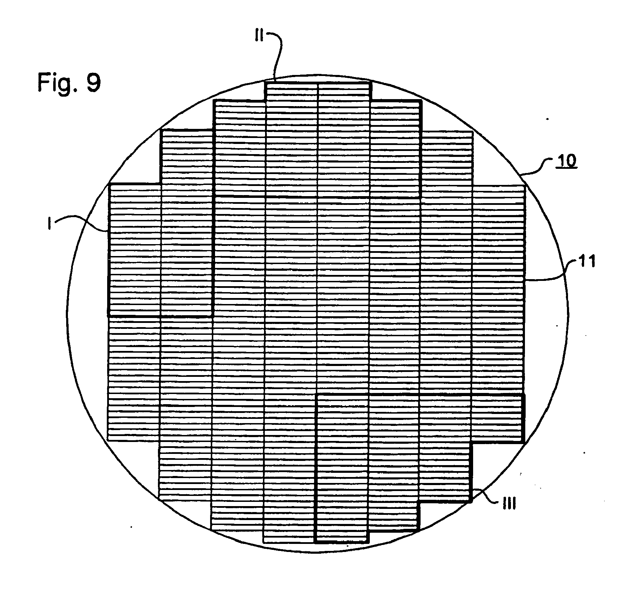

A second embodiment of the invention, which is the same as the first embodiment save as described below, is shown in Figures 7 and 8.

As shown in Figure 7, the second embodiment has facet masking means 12, 13 proximate the field facet mirror 10. The facet masking means 12, 13 may comprise a partially-opaque masking blade and a solid masking blade as in the first embodiment or simply a solid masking blade. Placing the facet masking means at the field faceted mirror rather than the pupil faceted mirror can be advantageous in that the field facets are generally larger in one direction than the pupil facets so that there is additional room to provide the necessary mechanisms and it is easier to construct the partially-opaque masking blades at a larger scale. However, additional advantages can be obtained if the field facets are arranged to fill pupil facets other than those in the corresponding location in the pupil mirror. For example, the outermost field facets 11a may be arranged to fill the innermost pupil facets 21b and vice versa, as shown in Figure 7. In that case, closing the facet masking means 12, 13 to obscure the outermost field facets 11a removes the illumination from the innermost pupil facets 21b, providing an annular illumination mode.

Figure 8 shows the field facet mirror 10, which is the same as in the first embodiment. The field facet mirror 10 comprises a plurality of field facets 11 which are rectangular with a high aspect ratio and arranged in rows and columns. The facet masking means 12 can be embodied as a plurality of selectively extendible fingers as in the pupil facet masking means of the first embodiment or as simple blades for masking a whole block of field facets 11 at a time.

The correspondence between the various pupil facets and field facets can be chosen such that an area of adjacent field facets 11 on field facet mirror 10 corresponds to a specific set of pupil facets 21 on pupil facet mirror 20. For instance, area I of field facets 11 may be chosen to correspond to a ring of pupil facets 21, area II to correspond to another ring of pupil facets and area III to an inner circular area of pupil facets 21. Areas I, II and III are easily blocked by respective masking blades, whereas it might be much harder to block only the corresponding pupil facets, enabling the selection of different σ values or annular illumination. Different arrangements of the correspondence between field and pupil facets can be used to provide other illumination modes, such as dipole and quadrupole configurations and configurations that are complementary to the above configurations.

Of course, the facet masking means of the first embodiment may be combined with that of the second embodiment to provide independent control of the inner and outer radii of an annular illumination mode (σᵢₙₙₑᵣ and σ ₒᵤₜₑᵣ).

Whilst specific embodiments of the invention have been described above, it will be appreciated that the invention may be practiced otherwise than as described. The description is not intended to limit the invention as defined in the claims.

## Claims

1. A lithographic projection apparatus comprising:
- a radiation system (Ex, IL) comprising reflective optical elements (10, 20, 30) for supplying a projection beam of radiation, said reflective optical elements including a first faceted mirror (10) for generating a plurality of source images on a second faceted mirror (20);
- a support structure (MT) for supporting patterning means (MA), the patterning means serving to pattern the projection beam according to a desired pattern;
- a substrate table (WT) for holding a substrate (W);
- a projection system (PL) for projecting the patterned beam onto a target portion of the substrate, and
- facet masking means (12, 13) for selectively masking the whole of one or more of the facets of said first faceted mirror.
**characterized by**:
facets near the periphery of the first facet mirror (10) being arranged to direct radiation to more centrally positioned facets of the second facet mirror (20).

2. Apparatus according to claim 1 wherein a group of adjacent facets (I; II; III) of the first faceted mirror (10) are arranged to direct radiation to a set of facets of the second faceted mirror (20), said set of facets of the second faceted mirror being arranged in a configuration selected from the group comprising:
substantially annular configurations;
multipole configurations;
substantially circular configurations; and
configurations complementary to the above configurations.

## Patentansprüche

1. Ein lithographisches Projektionsgerät, das Folgendes beinhaltet:
- ein Strahlungssystem (Ex, IL), das reflektierende optische Elemente (10, 20, 30) zum Liefern eines Projektionsstrahls aus Strahlung beinhaltet, wobei die reflektierenden optischen Elemente einen ersten facettierten Spiegel (10) zum Erzeugen einer Vielzahl von Quellenbildern auf einem zweiten facettierten Spiegel (20) umfassen;
- eine Stützstruktur (MT) zum Stützen eines Musteraufbringungsmittels (MA), wobei das Musteraufbringungsmittel dazu dient, den Projektionsstrahl gemäß einem gewünschten Muster zu mustern;
- einen Substrattisch (WT) zum Halten eines Substrats (W);
- ein Projektionssystem (PL) zum Projizieren des gemusterten Strahls auf einen Zielabschnitt des Substrats und
- Facettenmaskierungsmittel (12, 13) zum selektiven Maskieren der Gesamtheit einer oder mehrerer der Facetten des ersten facettierten Spiegels,
**dadurch gekennzeichnet, dass**
Facetten nahe dem Rand des ersten Facettenspiegels (10) angeordnet sind, um Strahlung zu Facetten des zweiten Facettenspiegels (20), die zentraler positioniert sind, zu lenken.

2. Gerät gemäß Anspruch 1, wobei eine Gruppe von benachbarten Facetten (I; II; III) des ersten facettierten Spiegels (10) angeordnet ist, um Strahlung zu einem Satz Facetten des zweiten facettierten Spiegels (20) zu lenken, wobei der Satz Facetten des zweiten facettierten Spiegels in einer Konfiguration angeordnet ist, ausgewählt aus der Gruppe, die Folgendes beinhaltet:
im Wesentlichen ringförmige Konfigurationen;
Multipolkonfigurationen;
im Wesentlichen kreisförmige Konfigurationen; und
Konfigurationen, die zu den obigen Konfigurationen komplementär sind.

## Revendications

1. Un appareil de projection lithographique comprenant :
- un système de rayonnement (Ex, IL) comprenant des éléments optiques réfléchissants (10, 20, 30) pour fournir un faisceau de projection de rayonnement, lesdits éléments optiques réfléchissants incluant un premier miroir à facettes (10) pour générer une pluralité d'images de source sur un deuxième miroir à facettes (20) ;
- une structure formant support (MT) pour supporter un moyen pour conformer selon un motif (MA), le moyen pour conformer selon un motif servant à conformer le faisceau de projection selon un motif souhaité ;
- une table porte-substrat (WT) pour porter un substrat (W) ;
- un système de projection (PL) pour projeter le faisceau à motif sur une portion cible du substrat, et
- des moyens de masquage de facette (12, 13) pour masquer de façon sélective l'intégralité d'une ou de plusieurs des facettes dudit premier miroir à facettes,
**caractérisé par le fait que** :
des facettes proches de la périphérie du premier miroir à facettes (10) sont arrangées pour diriger le rayonnement vers des facettes positionnées de façon plus centrale du deuxième miroir à facettes (20).

2. Appareil selon la revendication 1 dans lequel un groupe de facettes adjacentes (I; II; III) du premier miroir à facettes (10) sont arrangées pour diriger le rayonnement vers un jeu de facettes du deuxième miroir à facettes (20), ledit jeu de facettes du deuxième miroir à facettes étant arrangées selon une configuration sélectionnée dans le groupe comprenant :
des configurations substantiellement annulaires ;
des configurations multipolaires ;
des configurations substantiellement circulaires ; et
des configurations complémentaires aux configurations ci-dessus.
